Europäisches Patentamt

European Patent Office

Office européen des brevets

(11) Publication number: **0 097 772**
**B1**

(12) **EUROPEAN PATENT SPECIFICATION**

(45) Date of publication of patent specification: **07.06.89**  (51) Int. Cl.⁴: **H 01 L 29/06, H 01 L 21/20**

(21) Application number: **83103163.8**

(22) Date of filing: **30.03.83**

(54) **Structure comprising a monocrystalline substrate supporting a device layer of semiconductor material.**

(30) Priority: **30.06.82 US 393951**

(43) Date of publication of application:
**11.01.84 Bulletin 84/02**

(45) Publication of the grant of the patent:
**07.06.89 Bulletin 89/23**

(84) Designated Contracting States:
**DE FR GB**

(56) References cited:
**FR-A-2 386 903**
**FR-A-2 462 027**
**GB-A-1 319 560**
**US-A-3 954 534**
**US-A-4 035 829**
**US-A-4 157 556**
**US-A-4 160 261**
**US-A-4 194 935**
**US-A-4 236 166**

(73) Proprietor: **International Business Machines Corporation**
**Old Orchard Road**
**Armonk, N.Y. 10504 (US)**

(72) Inventor: **Hovel, Harold John**
**Diane Court**
**Katonah New York 10536 (US)**
Inventor: **Rosenberg, Robert**
**101 Lakeview Avenue West**
**Peekskill New York 10566 (US)**

(74) Representative: **Hobbs, Francis John**
**IBM United Kingdom Limited Intellectual Property Department Hursley Park**
**Winchester Hampshire SO21 2JN (GB)**

## Description

This invention relates to structures comprising a monocrystalline substrate supporting a device layer of semiconductor material. Intermetallic semiconductor material crystals of more than one element such as GaAs and GaAlAs have a number of properties useful in integrated circuit structures but to take full advantage of those properties it is necessary to build the integrated circuit structure in a thin layer with properties that produce device advantages supported by a substrate with different properties. It is desirable that the properties of the substrate have minimal effect on the properties of the device layer.

One integrated circuit structure in use in the art involves making the integrated circuit in a layer of GaAs on a substrate of high resistivity or semi-insulating GaAs. In this structure impurities in the doping that renders the substrate semi-insulating have a detrimental effect on device performance.

Another integrated circuit-structure developed in the art involves the making and the isolating of integrated circuits in a layer of GaAs on a substrate of $Al_2O_3$ as described in Metallurgical Transactions Vol. 1, March 1970, pages 623—628 and in Journal of Applied Physics Vol. 42, No. 6, May 1971, pages 2519—2527. In this type of structure, problems are encountered with crystal defects at the GaAs—$Al_2O_3$ interface.

Still another semiconductor structure involves selectively doped very thin layers of different semiconductor materials. This structure is known as a high electron mobility transistor (HEMT) and is described in the Japanese Journal of Applied Physics, Vol. 19, No. 5, May 1980, pp. L225 to L227. This structure places very stringent requirements on the quality of the substrate and the semiconductor material adjacent the device.

A structure comprising a GaAs active layer, a $Ga_{1-x}Al_xAs$ $(0 \leq x \leq 0.40)$ buffer layer and an $Al_2O_3$ substrate is known from FR—A—2 462 027.

The invention concerns a structure comprising a monocrystalline substrate consisting of sapphire ($\alpha$-$Al_2O_3$), spinel or ZnSe and supporting a device layer of GaAs semiconductor material in which semiconductor devices can be formed, and an intermediate, lattice accommodating epitaxial layer of GaAlAs positioned between the monocrystalline substrate and said device layer, the structure further comprising a lattice-spacing-transition-improving layer of Ge positioned between the monocrystalline substrate and the intermediate layer of GaAlAs.

The invention may be viewed as an intermediate manufacturing product which may be employed in a variety of ways to achieve integrated circuit stucture benefits.

The invention will now be described by way of example, with reference to the accompanying drawings, in which:—

FIG. 1 represents an intermediate structure of the structure of the invention; and

FIGS. 2, 3 and 4 represent various structures embodying the invention.

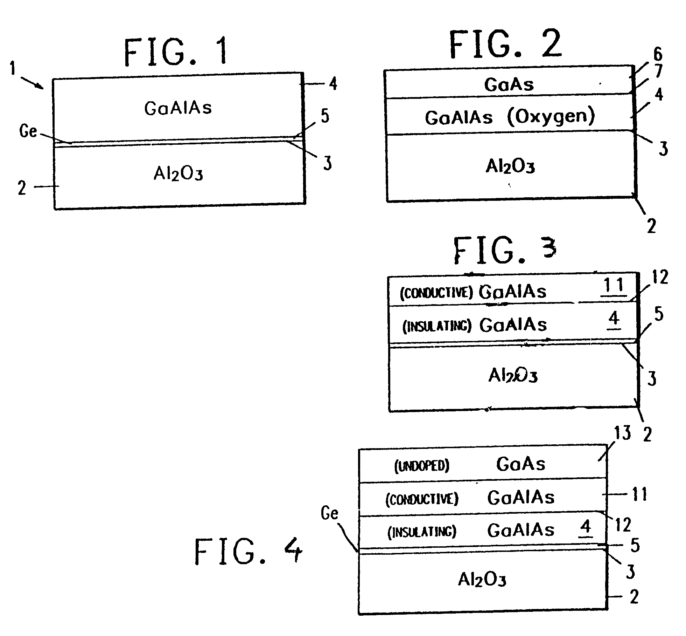

Referring to FIG. 1, the structure 1 has a monocrystalline insulating substrate 2 which is joined at a line of demarcation 3 with an epitaxial layer 4 of GaAlAs. The GaAlAs layer 4 is generally undoped but may contain conductivity type determining impurities in accordance with the properties desired to be imparted to the ultimate integrated circuit structure. Since GaAlAs may have varying quantities of Ga and Al usually described as $Ga_xAl_{1-x}As$ where x varies from about 0.1 to 0.9 and the electrical and optical properties vary with x, much flexibility can be achieved. The GaAlAs intermediate layer 4 is epitaxial with the crystalline substrate 2 and provides a barrier to electrons, in a device layer which will be formed over the exposed surface of at least portions of the layer 4, from interacting with interface defects at the interface 3. The GaAlAs intermediate layer 4 also permits wide differences in resistance properties in the material chosen for the substrate 2 from affecting the properties of the integrated circuit devices. A thin layer 5 of Ge is included in order to improve the lattice spacing transition from the spacing of the substrate 2 to that of the GaAlAs layer 4.

The substrate 2 is of a crystalline material with crystal structure and lattice spacing compatible with epitaxial growth of the GaAlAs layer 4. The substrate may be of sapphire ($\alpha$-$Al_2O_3$), spinel or ZnSe. The substrate may be chosen to impart a variety of properties such as resistance and thermal conductance.

The structure 1 may be employed in various types of integrated circuit structures as illustrated in FIGS. 2, 3 and 4.

Referring next to FIG. 2, the intermediate structure of FIG. 1 is provided with an epitaxial device layer 6 of GaAs in which an integrated circuit is to be formed. The layer 6 joins the GaAlAs layer 4 epitaxially at an interface 7. In FIG. 2, the region 4 and the region 6 may be provided with oxygen in the few parts per million range. This causes the GaAlAs layer 4 to be highly insulating. The oxygen will also give the GaAs layer 6 high resistivity so that processing operations such as ion implantation to produce arrays of field effect transistors may be employed.

In FIG. 2, while the Ge lattice accommodation layer 5 is not shown, the addition of a 5 micrometers thickness layer 5 of Ge permits a wider lattice spacing tolerance in the selection of the material for the substrate 2.

Referring next of FIG. 3, the GaAlAs region 4 is made insulating and is equipped with a conductive GaAlAs layer 11 epitaxially joined to the region 4 at an interface 12. The layer 11 may be formed by the techniques of ion implantation, diffusion or vapor growth.

Referring next to FIG. 4, a layer 12 of undoped GaAs is added to the structure of FIG. 3 where the GaAs layer 13 and the conductive GaAlAs layer 11 are at least 0.06 micrometers thick to provide an improved structure for the high electron mobility transistor (HEMT) device currently receiving attention in the art. In this type of device the layers are so thin that advantage can be taken of the spatial separation beteen electrons and their parent donor impurities.

Additional advantages occur with the practice of the invention. Misfit dislocations at the interface 3 will be passive in structures employing the invention as opposed to the conditions present in the "silicon on saphhire" type structures common in the silicon industry. Further imperfections originating at the interface 3 will propagate in the intermediate layer 4 but will not grow perpendicular to the interfaces 7 and 12 between the intermediate and device layers and when they reach the device layers 6 and 11 they will propagate parallel to the interfaces 7 and 12 resulting in a higher quality device layer.

A preferred embodiment of the invention is a structure similar to FIG. 2 with a substrate 2 of $Al_2O_3$ of sufficient thickness for handling. A 2 to 20 micrometers thick layer 4 of $Ga_{0.5x}Al_{1-0.5x}As$ is epitaxially grown thereon, through the technique of the decomposition of vapors of trimethyl aluminum, trimethyl gallium and arsine. This is followed by a layer of GaAs of at least 0.1 micrometers thickness in which no Al-containing vapor is provided in the growth with the Ga source and the As source. In order for the GaAs layer 6 to be useful for active devices, it should have an average carrier mobility of the order of 5,000 centimetres$^2$ per volt second and have a doping concentration between $10^{15}$ and $10^{16}$ atoms per cc. The Ge layer 5 is grown first on the $Al_2O_3$ to a depth of around 5 micrometers followed by the GaAlAs described.

Alternatively, the GaAs layer 6 could be 2 to 20 microns thick and oxygen doped to give it high resistivity and a technique such as ion implantation used to form the active device region.

What has been described is a structure for the fabrication of integrated circuits wherein an intermediate layer of GaAlAs and Ge is provided between the substrate and the device layer.

## Claims

1. A structure comprising a monocrystalline substrate (2) consisting of sapphire (α-$Al_2O_3$), spinel or ZnSe and supporting a device layer (6) of GaAs semiconductor material in which semiconductor devices can be formed, and an intermediate, lattice accommodating epitaxial layer (4) of GaAlAs positioned between the monocrystalline substrate (2) and said device layer (6), the structure further comprising a lattice-spacing-transition-improving layer (5) of Ge positioned between the monocrystalline substrate and the intermediate layer of GaAlAs.

2. A structure as claimed in claim 1, in which the layer (5) of Ge is 5 micrometers thick.

3. A structure as claimed in claim 1 or claim 2, in which the intermediate layer (4) of GaAlAs is from 2 to 20 micrometers thick.

4. A structure as claimed in any preceding claim, in which both said device layer and the intermediate layer are doped with oxygen.

## Patentansprüche

1. Struktur mit einem monokristallinen Substrat (2), bestehend aus Saphir (α-$Al_2O_3$), Spinell oder ZnSe als Träger für eine Schichtanordnung (6) aus einem GaAs-Halbleitermaterial, in welcher Halbleiterbauelemente gebildet werden können und einer epitaxialen, ein Gitter beherbergenden Zwischenschicht (4) aus GaAlAs, die zwischen dem monokristallinen Substrat (2) und der Schichtanordnung (6) angeordnet ist, wobei die Struktur weiterhin eine das Gitter beabstandende, übergangsverbessernde Schicht (5) aus Ge umfaßt, die zwischen dem monokristallinen Subsrat und der Zwischenschicht (4) aus GeAlAs angeordnet ist.

2. Struktur nach Anspruch 1, in der die Schicht (5) aus Ge 5 Mikrometer dick ist.

3. Struktur nach Anspruch 1 oder 2, in der die Zwischenschicht (4) aus GaAlAs zwischen 2 und 20 Mikrometer dick ist.

4. Struktur nach einem der vorhergehenden Ansprüche, in welcher beide, die Schichtanordnung (6) und die Zwischenschicht (4) mit Sauerstoff dotiert sind.

## Revendications

1. Structure comportant un substrat monocristallin (2) constitué de saphir (α-$Al_2O_3$), spinelle ou ZnSe et portant une couche pour un dispositif (6) de matériau semiconducteur GaAs dans laquelle des dispositifs semiconducteurs peuvent être formés, et une couche de GaAlAs (4) intermédiaire, épitaxiale d'adaptation des réseaux cristallins placée entre le substrat monocristallin (2) et ladite couche pour un dispositif (6), la structure comportant en outre une couche de Ge (5) d'amélioration de la transition d'écart de maille placée entre le substrat monocristallin et la couche intermédiaire de GaAlAs.

2. Structure selon la revendication 1, dans laquelle la couche (5) de Ge a une epaisseur de 5 micromètres.

3. Structure selon la revendication 1 ou 2, dans laquelle la couche intermédiaire (4) de GaAlAs a une épaisseur de 2 à 20 micromètres.

4. Structure selon l'une quelconque des revendications précédents, dans laquelle la couche pour un dispositif et la couche intermédiaire sont dopées à l'oxygène.

FIG. 2

| 6 | 7 | 4 |
|---|---|---|
| GaAs |
| GaAlAs (Oxygen) | 3 |
| Al₂O₃ | 2 |

FIG. 3

| 12 | | | 11 |
|---|---|---|---|
| (CONDUCTIVE) GaAlAs | | |
| (INSULATING) GaAlAs | 5 | 4 |
| Al₂O₃ | 3 | 2 |
| | | 13 |

FIG. 1

| 4 |
|---|
| GaAlAs | 5 |
| | 3 |
| Al₂O₃ |

1 →   Ge   2

FIG. 4

| 13 | | | 11 |
|---|---|---|---|
| (UNDOPED) GaAs | | |
| (CONDUCTIVE) GaAlAs | | | 12 |
| (INSULATING) GaAlAs | 5 | 4 |
| Al₂O₃ | 3 | 2 |

Ge